# EUROPÄISCHE PATENTSCHRIFT

(11) **EP 2 526 462 B1**
(45) Veröffentlichungstag und Bekanntmachung des Hinweises auf die Patenterteilung: **27.11.2013**
(21) Anmeldenummer: 11706145.7
(22) Anmeldetag: 12.01.2011
(51) Int. Cl.: G03F 7/20, H01J 37/317, G03F 1/00, B82Y 10/00, B82Y 40/00

(54) **VERFAHREN ZUR STEUERUNG DER ELEKTRONENSTRAHL-BELICHTUNG VON WAFERN UND MASKEN MIT PROXIMITY-KORREKTUR**
METHOD FOR CONTROLLING THE ELECTRON BEAM EXPOSURE OF WAFERS AND MASKS WITH PROXIMITY EFFECT CORRECTION
PROCEDE POUR CONTROLER L'EXPOSITION DE FAISCEAU D'ELECTRONS DE PLAQUETTES ET DE MASQUES AVEC UNE CORRECTION DE PROXIMITE

(30) Priorität: 18.01.2010 DE 102010004939
(43) Veröffentlichungstag der Anmeldung: 28.11.2012
(73) Patentinhaber: Equicon Software GmbH Jena, 07745 Jena (DE)
(72) Erfinder: GALLER, Reinhard, 99423 Weimar (DE); KRÜGER, Michael, 07745 Jena (DE); MELZER, Detlef, 07751 Grosspürschütz (DE); SÜLZLE, Martin, 07745 Jena (DE)
(74) Vertreter: Kietzmann, Manfred
(86) Internationale Anmeldenummer: PCT/DE2011/000021
(87) Internationale Veröffentlichungsnummer: WO 2011/085719

(56) Entgegenhaltungen:
- GALLER R ET AL: "Geometrically Induced Dose Correction Method for e-Beam Lithography Applications", PROCEEDINGS OF THE SPIE - THE INTERNATIONAL SOCIETY FOR OPTICAL ENGINEERING SPIE - THE INTERNATIONAL SOCIETY FOR OPTICAL ENGINEERING USA, Bd. 7823, 24. September 2010 (2010-09-24), XP002633885, ISSN: 0277-786X
- GALLER R ET AL: "Modified Dose Correction Strategy for better Pattern Contrast", PROCEEDINGS OF THE SPIE - THE INTERNATIONAL SOCIETY FOR OPTICAL ENGINEERING SPIE - THE INTERNATIONAL SOCIETY FOR OPTICAL ENGINEERING USA, Bd. 7545, 15. Mai 2010 (2010-05-15), XP002633886, ISSN: 0277-786X
- EUNSUNG SEO ET AL: "Dose and shape modification proximity effect correction for forward-scattering range scale features in electron beam lithography", JAPANESE JOURNAL OF APPLIED PHYSICS, PART 1 (REGULAR PAPERS, SHORT NOTES & REVIEW PAPERS) JAPAN SOC. APPL. PHYS. JAPAN, Bd. 39, Nr. 12B, 11. Oktober 2000 (2000-10-11), Seiten 6827-6830, XP002633887, ISSN: 0021-4922 in der Anmeldung erwähnt
- EISENMANN H ET AL: "Proximity correction of high dosed frame with PROXECCO", PROCEEDINGS OF THE SPIE - THE INTERNATIONAL SOCIETY FOR OPTICAL ENGINEERING USA, Bd. 2194, 1. März 1994 (1994-03-01), Seiten 310-317, XP002633888, ISSN: 0277-786X
- MANAKLI S ET AL: "Complementary dose and geometrical solutions for electron beam direct write lithography proximity effects correction: Application for sub- 45-nm node product manufacturing", 13. August 2007 (2007-08-13), JOURNAL OF MICRO/ NANOLITHOGRAPHY, MEMS, AND MOEMS OCTOBER 2007 SPIE US, VOL. 6, NR. 3, XP002633889, das ganze Dokument
- OSAWA MORIMI ET AL: "Proximity effect correction using pattern shape modification and area density map for electron-beam projection lithography", JOURNAL OF VACUUM SCIENCE AND TECHNOLOGY: PART B, AVS / AIP, MELVILLE, NEW YORK, NY, US, Bd. 19, Nr. 6, 20. August 2001 (2001-08-20), Seiten 2483-2487, XP012009068, ISSN: 1071-1023, DOI: DOI:10.1116/1.1410090
- GALLER R ET AL: "A solution to meet new challenges on EBDW data prep", PROCEEDINGS OF THE SPIE - THE INTERNATIONAL SOCIETY FOR OPTICAL ENGINEERING SPIE - THE INTERNATIONAL SOCIETY FOR OPTICAL ENGINEERING USA, Bd. 7470, 15. Januar 2009 (2009-01-15), XP002633890, ISSN: 0277-786X

## Beschreibung

Die Erfindung betrifft ein Verfahren der Elektronenstrahl-Lithographie zur Herstellung von Wafern und Masken. Zur Verminderung der Auswirkungen des störenden Proximity-Effekts wird ein erweiterter Korrektur-Algorithmus zur Steuerung des Elektronenstrahls eingesetzt, der eine genauere Korrektur ermöglicht.

### Stand der Technik

Verfahren zur Erzeugung von Pattern mittels einer Elektronenstrahl-Belichtungsanlage sind seit längerem bekannt. Das benötigte Pattern wird in kleine Elementar-Figuren zerlegt und auf eine Schicht eines photoempfindlichen Lackes projiziert. Nach der Entwicklung des Resists soll sich das Pattern möglichst genau im Resist abbilden. Bei der Belichtung eines Resists mit einem Elektronenstrahl einer bestimmten Form (Gauss-Profil-Strahl oder Formstrahl oder Multi-Pixelstrahl) wird in dem Resist eine Dosis-Verteilung erzeugt, die nicht dem Dosisprofil des Elektronenstrahls entspricht. Die Ursache ist die Streuung der Elektronen an den Atomen bzw. Molekülen des Resists und des Substrates. Dieses wird als Proximity-Effekt bezeichnet.

Dabei kommt es zu einem Effekt mit geringer Reichweite (ca. 20 nm ... 40 nm, Vorwärtsstreuung) und einem mit deutlich längerer Reichweite (ca. 5.000 nm ... 30.000 nm, Rückwärtsstreuung). Daraus ergibt sich eine Verbreiterung des Elektronenstrahls ("Verschmierung der Dosisverteilung") und die gegenseitige Beeinflussung der Dosisverteilungen von unterschiedlichen Elementarfiguren, sodass schließlich, wenn alle gewünschten Elementarfiguren mit gleicher Dosis und unveränderter Geometrie belichtet werden, die im Resist erzeugte Dosisverteilung so verfälscht ist, dass die im Resist erzeugten Strukturen nicht die CDs (critical dimensions, minimale Strukturbreite) des gewünschten Pattern haben. Damit wird das erzeugte Pattern üblicherweise unbrauchbar für den gewünschten Zweck. Um diesen Effekt korrigieren zu können, muss zunächst ein mathematisches Modell für den Proximity-Effekt aufgestellt werden.

Als weithin akzeptiert gilt, dass der Effekt durch eine Überlagerung von zwei Gauss-Funktionen beschrieben werden kann (Formel (1)), wobei alpha und beta für die Reichweiten der Vorwärts- und Rückwärtsstreuung stehen und eta das Größenverhältnis der Effekte beschreibt.

Diese Funktion wird auch als Point Spread Function (PSF) bezeichnet. Damit sie in einem zunächst noch nicht bestimmten Korrekturverfahren verwendet werden kann, müssen die Parameter a und b bestimmt werden. Dazu werden nach verschiedenen Verfahren Belichtungen mit definiertem Testpattern durchgeführt und die CDs der Figuren auf den Testpattern im Resist ausgemessen. Dabei werden jedoch neben der PSF weitere Einflüsse mit vermessen und somit in die Kalibrierung mit aufgenommen.

Dies sind insbesondere der sog. Beam-Blur durch die Coulomb-Wechselwirkung der Elektronen untereinander und Linsenfehler der elektromagnetischen Abbildungssysteme und Effekte, die durch die Chemie des Resists beim Belichten und Entwickeln hervorgerufen werden. Deswegen wird diese über den gesamten Prozess kalibrierte Funktion im weiteren "Process Proximity Function" (PPF) genannt. Zur Definition der PPF kann es notwendig sein, das mehr als zwei Gauss-Funktionen überlagert werden.

Die resultierende Dosis-Verteilung lässt sich dann als Ergebnis der Faltungs-Operation der PPF mit dem Pattern selbst berechnen. Wie man sich leicht überzeugen kann, ist diese Funktion radialsymmetrisch, ortsunabhängig und nach außen hin monoton fallend.

Damit das durch die Elektronenstrahl-Lithographie erzeugte Resist-Pattern brauchbar wird, muss der (aus physikalischen Gründen) unvermeidbare Proximity-Effekt korrigiert werden. Bei Elektronenstrahl-Belichtungsanlagen, die eine Dosissteuerung des Elektronenstrahls unterstützen, wird üblicherweise so vorgegangen, dass die Figuren des Pattern solange in kleinere Figuren zerschnitten werden und für diese gegebenenfalls kleineren Figuren eine individuelle Dosis so berechnet wird, dass nach der Durchführung des gesamten Prozesses (Belichtung und Entwicklung des Resist), die Figuren des Pattern die gewünschte CD haben.

Ein für beliebige Pattern geeignetes Verfahren mit Dosis- bzw. Geometrie-Korrektur ist in der DE 4317899 C2 beschrieben und in der bekannten und kommerziell verfügbaren Software PROXECCO implementiert. Dieses Verfahren beruht auf dem mathematischen Verfahren der "Entfaltung durch geeignete Fourier-Transformationen", im weiteren kurz "Entfaltung" genannt. Ein weiteres Verfahren ist in der DE 198 18440 C2 offenbart.

Alle dem Stand der Technik entsprechenden KorrekturVerfahren leiden an einigen Problemen. Die uns bekannten Verfahren der Proximity-Korrektur funktionieren nur befriedigend, solange die CDs der Figuren im Pattern größer als etwa das 1,3-fache des alpha-Parameters (siehe Seo) der PPF ist. Der gegenwärtige Stand der Technik in der HalbleiterTechnologie verlangt aber CDs von ca. 35 nm, bis zum Jahr 2016 werden sogar 22 nm verlangt (ITRS-Roadmap). Gegenwärtig verfügbare und in der Halbleiter-Produktion anwendbare Lithographie-Prozesse haben (insbesondere durch die zu einem Prozess gehörenden Resiste) einen alpha-Parameter von ca. 25 ... 30 nm, d.h. eine Direktbelichtung ist nur bis hinunter zu ca. 38 ...45 nm möglich. Es ist eine Reihe von Vorschlägen bekannt, wie die Abbildungsqualität für bestehende Prozesse weiter verbessert werden kann, siehe z. B. US-PS 2008/0067446 A1. Alle diese Vorschläge zur Verbesserung der Korrektur setzen bei der Modifizierung des auf "Entfaltung" beruhenden Korrektur-Algorithmus an und haben bisher keine wesentlichen Qualitätsverbesserungen erbracht.

### Aufgabe der Erfindung

Aufgabe der Erfindung ist es deshalb, ein verbessertes Korrekturverfahren zu schaffen, mit dem der Kontrast und die CD aller Figuren eines Patterns optimal gesteuert werden können.
Eine weitere Aufgabe besteht darin, dieses Korrekturverfahren unabhängig von einem bestimmten bekannten Korrektur-Algorithmus und der Art der Beschreibung der PPF zu gestalten.

Erfindungsgemäß wird die Aufgabe entsprechend den Merkmalen des Anspruchs eins gelöst.
Diesem neuen Verfahren liegen nachfolgende Überlegungen und Erkenntnisse zugrunde.
Aus dem Modell des Proximity-Effektes folgt, dass für ein sehr spezielles Pattern die Korrektur des Proximity-Effektes ohne den mathematischen Apparat der "Entfaltung" ausgerechnet werden kann. Dieses Pattern ist ein in beiden Dimensionen einer Ebene unendlich ausgedehntes Muster aus Linien und Zwischenräumen mit gleichem Abstand.

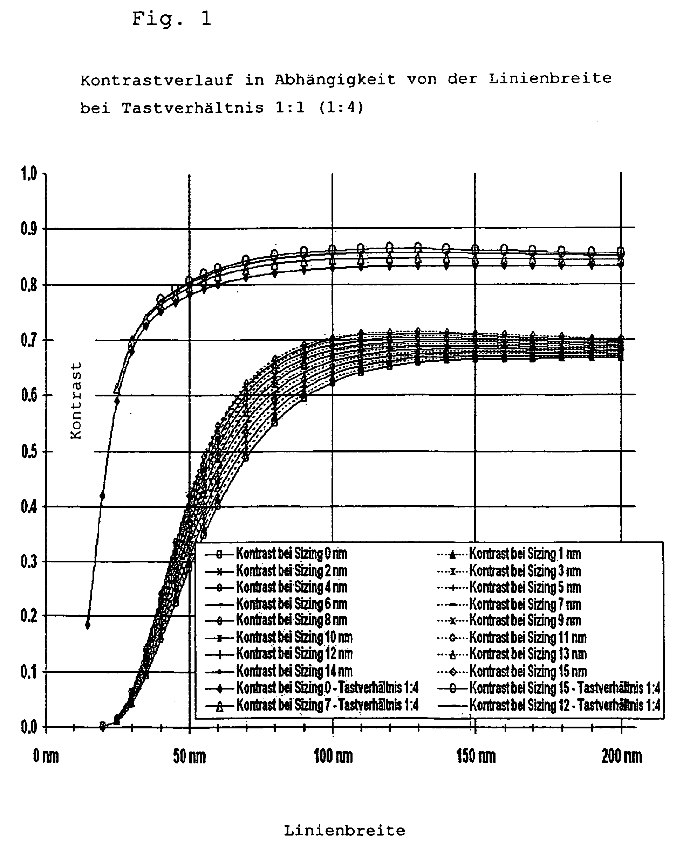

Bei der Berechnung der Dosis zeigt sich, dass die relative korrigierte Dosis für die Linien-Figuren immer gleich 1,0 ist, unabhängig von sowohl Linienbreite als auch von der konkreten PPF. Wenn man nun eine beliebige PPF zur Berechnung der resultierenden Dosis-Verteilung (Seo, Mack) (d.h. zur Simulation der Dosisverteilung) einsetzt, was wiederum ohne den mathematischen Apparat der Faltung möglich ist, so zeigt sich, dass der Resist-Kontrast erst beim ca. 0,65-fachen des alpha-Parameters endgültig verschwindet (siehe Fig. 1).

Kleinere Strukturen können also unter der Annahme eines Dense-Line-Pattern in keinem Falle abgebildet werden. Experimente zeigen (Seo), dass jedoch die Abbildungsgrenze in der Praxis schon bei ca. dem 1,3 fachen des alpha-Parameters erreicht wird. Da aber weder die Korrektur noch die Kalibrierung falsch sein können, weil dieses Ergebnis ja unabhängig von beiden eintritt, müssen auch alle Versuche, die Verbesserung der Abbildung in diesem Bereich durch andere Korrektur-Algorithmen oder Kalibrierung der PPF zu erreichen, zwangsläufig zum Scheitern verurteilt sein.

Die Ursache des Problems besteht darin, dass alle bekannten Verfahren versuchen, über eine Steuerung der CD der Figuren nach der Abbildung die "richtige" CD, d. h. die vor der Abbildung zu erreichen (CD-Steuerung). In dem genannten Bereich von ca. 0,65 alpha bis 1,3 alpha ist eine CD-Steuerung nicht hinreichend und muss durch eine Kontraststeuerung ergänzt werden. Auch wenn der Kontrast des Patterns (in den abzubildenden Pattern-Daten ist der Kontrast zwischen "Figur" und "Zwischenraum" immer = 1,0) nicht erreicht werden kann, muss eine Maximierung des verfügbaren Kontrastes durchgeführt werden, um im fraglichen Bereich eine Abbildung zu erreichen.

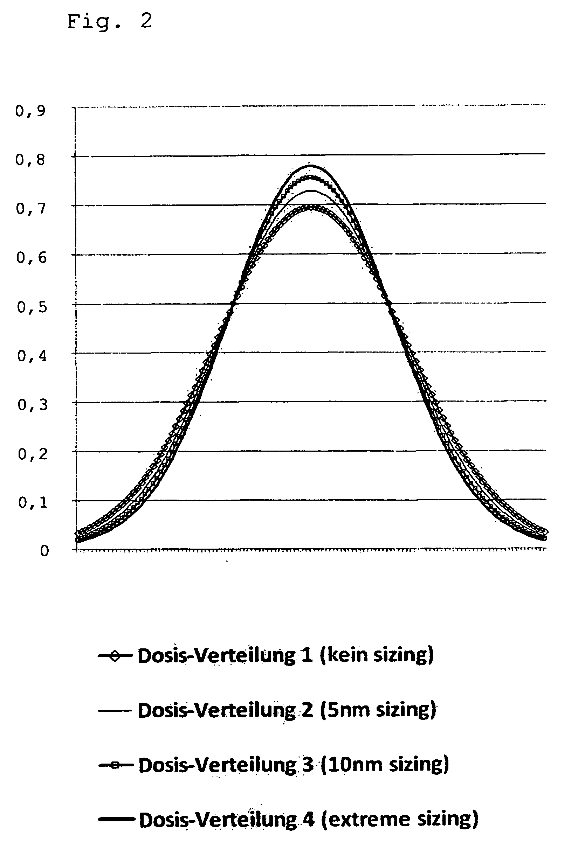

Es wird deshalb das Verfahren der geometrisch induzierten Dosis-Korrektur eingeführt. Die Steuerung des Kontrastes wird dabei durch den Sizing-Parameter S bestimmt (siehe Fig. 2).
Dabei wird durch einen Sizing-Operator die Größe einer Figur in x- und y-Richtung um jeweils den Betrag S (z. B. 10 nm) verkleinert. Anschließend wird die der Figur zugewiesene Dosis so korrigiert, dass der Belichtungsprozess, dessen PPF für die Korrektur verwendet wurde, bei einer Belichtung genau die Linienbreite der ursprünglichen Figur erzeugt. Die Kurven der Fig. 2 zeigen, dass tatsächlich die Linienbreite immer gleich ist, dass aber der Kontrast und vor allem der Gradient des Kontrastes an der Position des Resist-Threshold mit größer werdendem Sizing-Parameter ebenfalls größer werden.

Dieses Verfahren funktioniert offensichtlich gut bei Testpattern aus Figuren gleicher Linienbreite, ist aber für die Kontrast-Steuerung von allgemeinen Pattern noch nicht hinreichend. In allgemeinen Pattern sind nicht nur Figuren einer bestimmten Größe enthalten, sondern immer eine Mischung aus vielen.

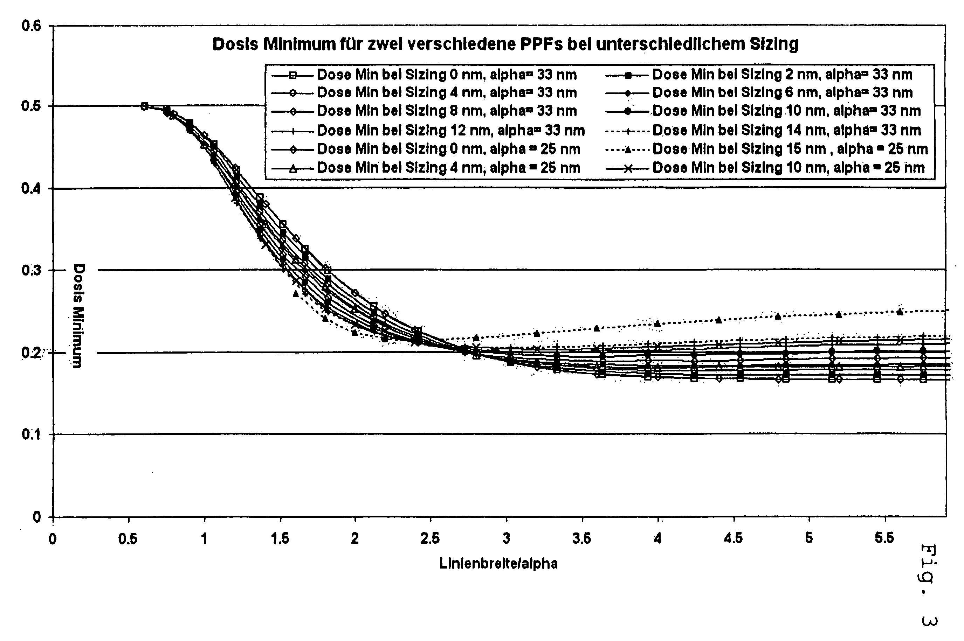

Es wurde jetzt gefunden, das es für alle PPF einen Umschlagpunkt im Kontrast in Abhängigkeit von der Figurbreite gibt. Dieser liegt beim etwa 2,5 fachen des alpha-Parameters der PPF. (siehe Fig. 3)
Von der Erkenntnis dieses physikalischen Sachverhalts wurden die neuen Verfahrensschritte abgeleitet. Wesentlich ist dabei die zusätzliche Einführung eines Parameters Kontraststempel-Breite K.
Das neue Verfahren nach Anspruch 1 ermöglicht durch eine gleichzeitige Steuerung von Kontrast und CDs bei der Elektronenstrahl-Belichtung eine hohe Abbildungsgenauigkeit aller Figuren eines Pattern.
Weitere bevorzugte Verfahrensvarianten zu den einzelnen Verfahrensschritten sind in den Unteransprüchen 2 bis 4 enthalten.

Im Unteranspruch 5 ist eine Verfahrensvariante aufgezeigt, die das erkennen von kleinen Lücken in großen Figuren ermöglicht. Damit wird bei der Abarbeitung des Korrektur-Algorithmus ein übergehen von kleinen Lücken sicher vermieden.

### Beispiele

Nachfolgend soll das Verfahren an einem Beispiel erläutert werden.
Die Figur 1 zeigt ein Diagramm des Kontrastverlaufes in Abhängigkeit von der Linienbreite,
Fig. 2 zeigt die Dosis-Verteilung bei verschiedenen Sizing-Parametern,
Fig. 3 stellt den Verlauf von Dosis-Minimum und Kontrast dar,
Fig. 4 enthält die Prinzipdarstellung eines Pattern mit der Figur F, und
Fig. 5 zeigt die Transformation von F in KR und R

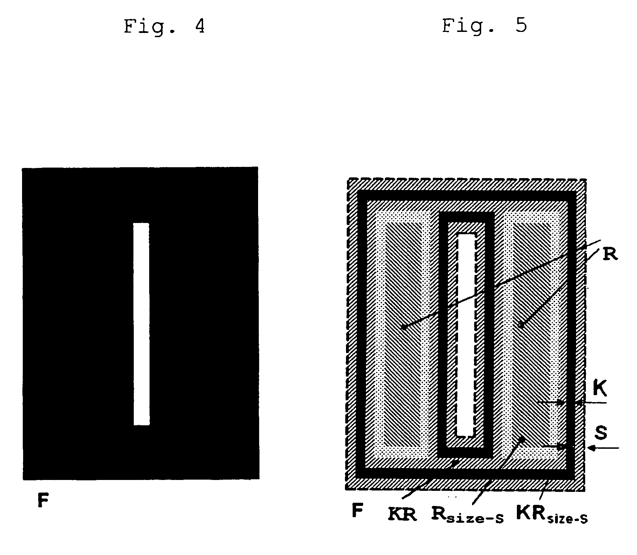

Die Figur F in Form eines Rechteckes mit einer eingebetteten linienförmigen Lücke in Fig. 4 möge als Muster für beliebig komplexe Figuren eines Pattern dienen. In einer ersten Operation wird aus F die Rest-Figur R erzeugt. Dies wird erreicht durch eine negative Sizing-Operation um den Betrag (2 x S+K). Der Kontrast-Rahmen KR wird erzeugt durch die geometrische Subtraktion der Restfiguren R von den Figuren F: KR = F \ R.

Die nun entstandenen Figuren Kontrastrahmen KR und Restfigur R werden jeweils durch eine negative Sizing-Operation um den Betrag von S zu KR_{size-S} und R_{size-S} verkleinert. KR_{size-S} und R_{size-S} werden dann zusammen dem Proximity-Korrektur-Algorithmus mit der Maßgabe übergeben, die Dosen jeweils so zuzuweisen, das der Resist-Threshold an den Kanten der Figur KR genau erreicht und auf dem Gebiet der Figur R garantiert überschritten wird.

### Verzeichnis der Bezugszeichen

- CD: Strukturbreite
- F: Figuren
- K: Kontraststempel-Breite
- KR: Kontrastrahmen
- KR_{size-S}: verkleinerter KR
- R: Rest-Figuren
- R_{size-S}: verkleinerte R
- S: Sizing-Parameter

### Nichtpatentliteratur

E. Seo, O. Kim, "Dose and Shape Modification Proximity Effect Correction for Forward Scattering Range Scale Features in Electron Beam Lithography", Jpn. J. Appl. Phys. Vol. 39 (2000) pp. 6827-6830
C. Sauer, C.A. Mack, "Electron-beam lithography simulation for mask making, part IV: Effect of resist contrast on isofocal dose", Photomask and X-Ray Mask Technology VI, Proc. SPIE Vol. 3748 (1999)

## Patentansprüche

1. Verfahren zur Steuerung der Elektronenstrahl-Belichtung von Wafern und Masken mit Proximity-Korrektur durch einen Korrektur-Algorithmus, **dadurch gekennzeichnet,**
- **dass** mit einem geometrischen Verfahren zusätzliche Kontrastrahmen (KR) und Rest-Figuren (R) zur Kontraststeuerung zu allen Figuren (F) erzeugt werden,
- von den Figuren Kontrastrahmen (KR) und Rest-Figuren (R) durch eine negative Sizing-Operation kleinere Figuren (KR_{size-S} und R_{size-S}) erzeugt werden
und anschließend diese Figuren (KR_{size-S} und R_{size-S}) in den Proximity-Korrektur-Algorithmus überführt werden mit der Bedingung, dass durch die Dosis-Zuweisung der Resist-Threshold an den Kanten der Figuren (KR, R) erreicht wird.

2. Verfahren nach Anspruch 1, **dadurch gekennzeichnet,**
**dass** das geometrische Verfahren aus nachfolgenden Schritten besteht
- aus der Figur (F) wird eine Rest-Figur (R) erzeugt durch eine negative Sizing-Operation um den Betrag 2 x Sizing-Parameter (S) + Kontraststempel-Breite (K),
- der Kontrastrahmen (KR) wird erzeugt durch die geometrische Subtraktion der Rest-Figur (R) von der Figur (F),
- die entstandenen Figuren (R und KR) werden dann durch eine negative Sizing-Operation verkleinert um den Betrag von Sizing-Parameter (S) zu KR_{size-S} und R_{size-S}.

3. Verfahren nach Anspruch 1, **dadurch gekennzeichnet,**
**dass** die Rest-Figuren (R) in den Proximity-Korrektur-Algorithmus mit der Bedingung überführt werden, dass nur eine solche Dosis zugewiesen wird, dass der Resist-Threshold für die gesamten Rest-Figuren (R) garantiert überschritten wird.

4. Verfahren nach einem der Ansprüche 1 bis 3, **dadurch gekennzeichnet,**
**dass** zur sicheren Erkennung von kleinen Lücken in großen Figuren (in große Figuren eingebettete invertierte Figuren) dem Korrektur-Algorithmus das Original-Pattern und das durch Tonwertumkehr invertierte Pattern gleichzeitig übergeben und bei der Zerlegung der Pattern in Elementarfiguren und Zuweisung der korrigierten Dosis zu diesen Elementarfiguren beide Tonwerte berücksichtigt werden.

## Claims

1. A method for controlling the electron beam exposure of wafers and masks using proximity correction through a correction algorithm, **characterized in that**
- additional contrast frames (KR) and remaining figures (R) are produced using a geometrie method for the purpose of contrast control with respect to all figures (F),
- smaller figures (KR_{size-S} and R_{size-S}) are produced from the contrast frame figures (KR) and remaining figures (R) by means of a negative sizing operation,
and subsequently said figures (KR_{size-S} and R_{size-S}) are transferred to the proximity correction algorithm with the condition that the resist threshold is reached at the edges of the figures (KR, R) due to the dose assignment.

2. The method of claim 1, **characterized in that**
the geometrie method consists of the following steps:
- a remaining figure (R) is produced from the figure (F) by means of a negative sizing operation by the value 2 x sizing parameter (S) + contrast stamp width (K),
- the contrast frame (KR) is produced by means of the geometrie subtraction of the remaining figure (R) from the figure (F),
- the resulting figures (R and KR) are then reduced to KR_{size-S} and R_{size-S} by the value of the sizing parameter (S) by means of a negative sizing operation.

3. The method of claim 1, **characterized in that**
the remaining figures (R) are transferred to the proximity correction algorithm with the condition that a dose is assigned only to such extent that the resist threshold is guaranteed to be exceeded for all the remaining figures (R).

4. The method of any one of claims 1 to 3, **characterized in that**
the reliable detection of small gaps in large figures (inverted figures embedded in large figures) is ensured by passing the original pattern and the inverted pattern proauced by tone value inversion to the correction algorithm simultaneously and by taking both tone values into account when breaking the patterns down into elementary figures and assigning the corrected dose to said elementary figures.

## Revendications

1. Procédé pour la commande de l'exposition de tranches et de masques à un faisceau d'électrons avec correction de proximité par un algorithme de correction, **caractérisé en ce que**
- avec un procédé géométrique, des cadres de contraste (KR) et figures restantes (R) supplémentaires sont produits pour la commande du contraste de toutes les figures (F),
- des figures plus petites (KR_{size-S} et R_{size-S}) des cadres de contraste (KR) et des figures restantes (R) sont produites par une opération de negative sizing et puis ces figures (KR_{size-S} et R_{size-S}) sont transférées dans l'algorithme de correction de proximité à la condition que, par l'affectation de dose, le seuil de réserve soit atteint au niveau des bords des figures (KR, R).

2. Procédé selon la revendication 1, **caractérisé en ce que** le procédé géométrique se compose des étapes suivantes :
- une figure restante (R) est produite à partir de la figure (F) par une opération de negative sizing dont la valeur correspond à 2 x Sizing Parameter (S) + largeur d'estampe de contraste (K),
- le cadre de contraste (KR) est produit par la soustraction géométrique de la figure restante (R) à partir de la figure (F),
- les figures (R et KR) créées sont ensuite réduites par une opération de negative sizing dont la valeur correspond au Sizing Parameter (S) pour KR_{size-S} et R_{size-S}.

3. Procédé selon la revendication 1, **caractérisé en ce que**
les figures restantes (R) sont transférées dans l'algorithme de correction de proximité à la condition que la dose affectée soit uniquement celle pour laquelle le seuil de réserve est dépassé de façon garantie pour toutes les figures restantes (R).

4. Procédé selon une des revendications 1 à 3, **caractérisé en ce que**,
pour l'identification sûre de petits espaces vides dans de grandes figures (figures inversées noyées dans de grandes figures), le pattern original et le pattern inversé par inversion de valeur de ton sont transférés simultanément à l'algorithme de correction et, lors de la décomposition des patterns en figures élémentaires et lors de l'affectation de la dose corrigée à ces figures élémentaires, les deux valeurs de ton sont prises en compte.
